# EUROPÄISCHE PATENTSCHRIFT

(11) **EP 4 141 377 B1**
(45) Veröffentlichungstag und Bekanntmachung des Hinweises auf die Patenterteilung: **01.10.2025**
(21) Anmeldenummer: 22182999.7
(22) Anmeldetag: 05.07.2022
(51) Int. Cl.: G01R 31/58, H04B 3/46

(54) **ANLAGE UND PRÜFVERFAHREN FÜR DIE KABELKONFEKTION**
APPARATUS AND TESTING METHOD FOR ASSEMBLING A CABLE
INSTALLATION ET PROCÉDÉ D'ESSAI POUR LA FABRICATION DE CÂBLES

(30) Priorität: 23.08.2021 DE 102021121769
(43) Veröffentlichungstag der Anmeldung: 01.03.2023
(73) Patentinhaber: MD ELEKTRONIK GmbH, 84478 Waldkraiburg (DE)
(72) Erfinder: Spielbauer, Wolfgang, 84524 Neuötting (DE); Riegl, Christoph, 83512 Wasserburg am Inn (DE)

(56) Entgegenhaltungen:
- EP-A2- 1 271 165
- DE-B3- 102018 130 626
- DE-U1- 202016 102 194
- US-A- 4 285 118
- US-A1- 2013 162 262

## Beschreibung

### Technisches Gebiet

Die Erfindung betrifft eine Anlage zur Kabelkonfektion sowie ein Prüfverfahren für die Kabelkonfektion an einer Anlage.

### Stand der Technik

In der automatisierten Kabelkonfektion, bei der zumindest ein Stecker automatisiert an einer Leitung befestigt wird, werden im Stand der Technik in finalen Prozessschritten Gleichstrom-Eigenschaften einer konfektionierten Leitung mit einem Kabeltester geprüft. Die Gleichstrom-Eigenschaften umfassen Durchgang, Kurzschluss und/oder Isolation. Das Bestimmen der Länge einer Leitung erfolgt im Stand der Technik lediglich stichprobenartig in einem manuellen Prozessschritt, der u.a. das Öffnen eines Kabel-Coils und Messen der Leitungslänge vorsieht. Die Prüfung einer einseitig konfektionierten Leitung erfolgt auch nur auf Gleichstrom-Basis mit Kurzschluss und Isolationstest. Hochfrequenz-Eigenschaften, wie Reflektion, Impedanz und/oder Laufzeit, können mit einem Kabeltester aus dem Stand der Technik jedoch nicht geprüft werden.

Die Druckschrift KR 20 200 065 167 A betrifft eine Vorrichtung zum Messen einer Kabellänge eines Kabels, dass auf einer Rolle, insbesondere einer schweren Kabeltrommel, aufgewickelt ist. Ein TDR (Time Domain Reflectometry) Längensensor wird dabei an einem inneren offenen Ende des Kabels innerhalb der Trommel befestigt und misst die verbleibende Länge des Kabels auf der Rolle.

Die Druckschrift US 2005 052 190 A1 betrifft ein digitales TDR-System. In der Druckschrift wird beschrieben, wie die Länge eines Kabels, das sich noch auf einer Rolle aufgewickelt befindet, bestimmt werden kann. Die Genauigkeit des TDR-Systems wird erhöht, indem mehrere Messungen durchgeführt werden und ein Mittelwert bestimmt wird.

Die Druckschrift US 2013 162 262 A1 betrifft ein System zum Testen eines Kabelbaums. Das System umfasst eine oder mehrere TDR-Engines und ermöglicht es nacheinander einen TDR-Stimulus auf die Zweige des Kabelbaums anzuwenden und die resultierenden TDR-Wellenformen zu sammeln. Die Wellenformen werden analysiert, um festzustellen, ob der Kabelbaum Qualitätsstandards entspricht. Insbesondere wird eine Kabelbaumvorrichtung (harness jig) verwendet, um den Kabelbaum an das System zu koppeln. Zum Koppeln drückt ein Bediener jeden Clip oder Träger des Kabelbaums in eine Halterung in der Kabelbaumvorrichtung.

Die Druckschrift WO 2014 204 484 A1 betrifft die Bestimmung einer Länge eines Kabels, das auf einer Rolle aufgewickelt ist. Zur Längenbestimmung werden Messungen im Ultraschallbereich durchgeführt.

Die Druckschrift US 4,285,118 A betrifft eine Vorrichtung zur Montage elektrischer Verbinder an einem mehradrigen flexiblen Flachkabel und insbesondere eine Vorrichtung zur gleichzeitigen Prüfung des Kabels und des Verbinders auf Unterbrechungen und Kurzschlüsse, während das Kabel mit dem Verbinder abgeschlossen wird.

Die im Stand der Technik beschriebenen Vorrichtungen und Systeme haben den Nachteil, dass sie nicht für die Integration in einen automatischen Prozessablauf geeignet sind. Insbesondere die Verbindung von zu prüfender Leitung und Messvorrichtung wird nicht beschrieben oder in einem manuellen Schritt durchgeführt. Daneben sind die beschriebenen Systeme nicht geeignet kurze Leitungen, d.h. mit Längen im unteren cm-Bereich, zu vermessen. Schließlich werden die Leitungen im Stand der Technik nur Single-Ended, d.h. gegen die Masse, vermessen, so dass keine mehradrigen Kabel vermessen werden können.

### Beschreibung der Erfindung

Es ist daher eine Aufgabe der vorliegenden Erfindung die oben genannten Nachteile zu überkommen und eine Vorrichtung sowie ein Verfahren bereitzustellen, die eine automatisierte Hochfrequenz-Prüfung von Leitungen, insbesondere konfektionierten Leitungen in einer Konfektionsanlage, ermöglichen.

Die oben genannte Aufgabe wird durch eine Anlage nach Anspruch 1 sowie ein Prüfverfahren nach Anspruch 7 gelöst. Weitere vorteilhafte Ausgestaltungsformen der Erfindung lassen sich den Unteransprüchen, der Beschreibung sowie den Zeichnungen entnehmen.

Erfindungsgemäß wird die oben genannte Aufgabe gelöst durch eine Anlage zur Kabelkonfektion aufweisend einen Leitungsträger, der eingerichtet ist zumindest eine Leitung zu transportieren und zu halten, eine TDR-Messvorrichtung, die eingerichtet ist Hochfrequenz-Messungen durchzuführen, und eine Kontaktiervorrichtung, die gegenüber der Leitung und der TDR-Messvorrichtung bewegbar ist, und die über eine Hochfrequenz-Verbindung mit der TDR-Messvorrichtung verbunden ist, wobei die Kontaktiervorrichtung die Leitung Hochfrequenz-tauglich kontaktieren kann.

Die Anlage zur Kabelkonfektion weist ein integriertes Prüfsystem auf. Eine automatisierte Konfektion einer Leitung mit einer End-of-line Prüfung der konfektionierten Leitung ist möglich. Insbesondere eine manuelle Prüfung, die ein Öffnen eines Leitungs-Coils, sowie ein Auslegen und Vermessen der Leitung auf einem Legebrett umfassen würde, entfällt. Weiterhin können mit einer TDR-Messung Unterbrechungen in der Leitung festgestellt werden. Der Prüfprozess wird insgesamt schneller und zuverlässiger.

Bevorzugt weist die TDR-Messvorrichtung zumindest zwei Kanäle auf, und die zumindest zwei Kanäle können im Einzelbetrieb oder im Differenzmodus betrieben werden. Im Einzelbetrieb können zwei Leitungen gleichzeitig gemessen werden. Dies verkürzt die Prüfzeiten insgesamt. Im Differenzmodus können mehrere Adern einer Leitung gegeneinander vermessen werden, so dass auch mehradrige Leitungen geprüft werden können.

Bevorzugt basiert die TDR-Messvorrichtung auf dem "sequential equivalent-time sampling" Verfahren, und weist Sprunggeneratoren auf, wobei die Sprunggeneratoren eine Anstiegszeit von weniger als 100 ps, bevorzugter weniger als 70 ps, am bevorzugtesten weniger als 65 ps, und eine Messbandbreite von mehr als 5 GHz, bevorzugter mehr als 8 GHz, und am bevorzugtesten mehr als 10 GHz, aufweisen. Insbesondere weist die TDR-Messvorrichtung keine Totzeiten auf. Durch die genannten Parameter können sehr kurze Signallaufzeiten vermessen werden, wodurch im Umkehrschluss sehr kurze Leitungslängen vermessen werden können. Da bei der Kabelkonfektion auch Leitungen mit Längen unter 30 cm (entspricht etwa 1 Fuß) konfektioniert werden, ist das Vermessen kurzer Leitungen von Vorteil. Daneben wird eine sehr hohe räumliche (der Länge nach) Auflösung erreicht. Die hohe Auflösung ermöglicht eine genaue Längenmessung und das genaue Erkennen von Unterbrechungen oder mechanischen Störungen, wie zum Beispiel eine an der Leitung angeschlossene Masseschelle, auf der Leitung. Die Messgeschwindigkeit für eine Leitung mit max. 16 m Länge liegt unter 4 s.

Bevorzugt kann die Leitung zu einem Coil aufgewickelt, und noch bevorzugter ein- oder zweiseitig konfektioniert sein. Eine Leitung wird bevorzugt zu einem Coil aufgewickelt um platzsparender und besser handhabbar zu sein. In einem automatisierten Prozess ist es von Vorteil, wenn die Leitung permanent als Coil gewickelt bleiben kann, da ein Öffnen des Coils Zeit braucht und eine ausgerollte Leitung umständlich zu handhaben ist. Bei der Kabelkonfektion wird eine Leitung ein oder zweiseitig konfektioniert, d.h. mit einem Anschlusselement wie einem Stecker oder einer Buchse, dauerhaft verbunden. Im Unterschied zu einer nichtkonfektionierten Leitung muss insbesondere bei der Leitungskontaktierung auf die Geometrie des Anschlusselements geachtet werden, damit eine zuverlässige Verbindung bereitgestellt wird.

Bevorzugt umfasst eine Hochfrequenz-taugliche Verbindung eine gleiche Impedanz von TDR-Messvorrichtung, Kontaktierung zur Leitung und Leitung. Gleiche Impedanz bedeutet dabei auch annähernd gleiche Impedanz, so dass Messsignale (Reflektionssignale) empfangen werden können, die für eine zuverlässige Messung geeignet sind. Die Impedanz ist insbesondere bei Hochfrequenz-Signalen von ausschlaggebender Bedeutung. Bei zu großen Impedanzunterschieden wird ein ausgesendetes Messsignal an den Übergängen von einem Medium in ein anderes zu stark abgeschwächt, so dass empfangene Messsignale zu schwach für ein zuverlässige Auswertung sind.

Die Kontaktiervorrichtung umfasst einen federgespannten Kontaktierstift. Die Federspannung erzeugt beim Andrücken der Leitung auf den Kontaktierstift eine dauerhafte Anpresskraft des Kontaktierstifts auf die Leitung bzw. das erste Leitungsende oder das Anschlusselement. Dadurch kann eine zuverlässige Kontaktierung zwischen Kontaktierstift und Leitung sichergestellt werden. Wäre die Verbindung nur lose, könnten ungewollte Bewegungen an der Anlage einen Spalt zwischen Leitung und Kontaktiervorrichtung verursachen. Der Spalt hätte einen signifikanten Impedanzunterschied zur Folge, der sich negativ auf die Hochfrequenz-Messungen auswirken würde.

Bevorzugt umfasst die TDR-Messvorrichtung einen Hochfrequenz-Multiplexer. Durch den Hochfrequenz-Multiplexer können mehrere Leitungen zeitgleich vermessen werden. Dadurch beschleunigt sich der Prüfprozess insgesamt.

Die Anlage weist weiterhin einen PC zur Steuerung von Messungen und zur Verarbeitung von gemessenen Daten der TDR-Messvorrichtung, und eine SPS zur Steuerung der automatischen Zuführung von Leitungen an der Kontaktiervorrichtung auf. In der automatisierten Kabelkonfektion sollen manuelle Schritte bis auf ein Minimum reduziert werden bzw. im Idealfall wegfallen. Durch den Einsatz eines PCs und einer SPS kann auf manuelle Schritte verzichtet werden. Der automatisierte Prozess ist schneller und oftmals zuverlässiger.

Die oben genannte Aufgabe wird weiterhin insbesondere gelöst durch ein Prüfverfahren für die Kabelkonfektion an einer Anlage, die zumindest einen Leitungsträger, eine Kontaktiervorrichtung und eine TDR-Messvorrichtung, die über eine Hochfrequenz-Verbindung mit der Kontaktiervorrichtung verbunden ist, umfasst, wobei das Verfahren die folgenden Schritte aufweist: Positionieren einer Leitung gegenüber der Kontaktiervorrichtung mittels des Leitungsträgers, Ausrichten der Kontaktiervorrichtung an der Leitung, so dass die Kontaktiervorrichtung in Kontakt mit der Leitung gebracht werden kann, Prüfen der Leitung mittels der TDR-Messvorrichtung, und nach dem Prüfen, Bewegen der Kontaktiervorrichtung in Richtung weg von der Leitung, so dass die Leitung mittels des Leitungsträgers frei bewegbar ist.

Alle Verfahrensschritte werden automatisiert ausgeführt und stellen eine zuverlässige Prüfung einer Leitung sicher. Insbesondere wird durch die Bewegung der Kontaktiervorrichtung eine zuverlässige, Hochfrequenz-taugliche Verbindung zwischen Leitung und TDR-Messvorrichtung erreicht. Dabei muss der Leitungsträger die zu prüfende Leitung lediglich in einem Prüfbereich positionieren, während die Kontaktierung von der Kontaktiervorrichtung ausgeführt und überwacht wird. Durch das Einführen der Leitung in die Kontaktiervorrichtung, bevorzugt in einer formschlüssigen Verbindung, entfallen zusätzliche Positionierschritte. Nach dem Prüfen der Leitung gibt die Kontaktiervorrichtung die Leitung frei, so dass der Leitungsträger zum Beispiel seine ursprüngliche Bewegung entlang einer zweiten Richtung quer zur Kontaktiervorrichtung fortführen kann. Die wenigen und oftmals eindimensionalen Bewegen sind für einen automatisierten Prozess von Vorteil.

Bevorzugt umfasst der Schritt des Ausrichtens der Kontaktiervorrichtung an der Leitung ein Andrücken der Kontaktiervorrichtung an die Leitung. Das Andrücken der Kontaktiervorrichtung, und insbesondere des Kontaktierstifts an der Leitung, ist eine einfache, zuverlässige und lösbare Verbindung zwischen Leitung und Kontaktiervorrichtung. So kann schnell eine Verbindung aufgebaut und nach erfolgter Messung wieder gelöst werden.

Bevorzugt umfasst der Schritt des Prüfens ein Bestimmen der Leitungslänge und/oder einer Unterbrechung der Leitung.

Bevorzugt umfasst der Schritt des Prüfens ein Bestimmen von Gleichstromeigenschaften. Neben den Hochfrequenz-Messungen können auch Gleichstromeigenschaften geprüft werden. Somit erfolgt eine umfassende Prüfung einer Leitung, was die Qualität aller Leitungen insgesamt erhöht.

Das Prüfverfahren weist weiterhin die Schritte auf: Weitertransportieren der Leitung zu einem nachfolgenden Prozessschritt, und Bereitstellen einer folgenden Leitung mittels des Leitungsträgers an der Kontaktiervorrichtung. Durch diese Prozessschritte ist ein geschlossener automatisierter Ablauf des Prüfens hergestellt.

Bevorzugt weist das Prüfverfahren weiterhin den Initialschritt auf: Kalibrieren des Prüfverfahrens über eine Messung an einer Leitung mit definierter Länge. Initialschritt bedeutet, dass die Kalibrierung einmalig vor der Durchführung einer Vielzahl von Leitungs-Prüfungen durchgeführt wird. Die Kalibrierung kann zum Beispiel zu Beginn der Inbetriebnahme einer Anlage, zu Beginn einer neuen Konfektionslinie, zu Schichtbeginn an einer Anlage oder zu anderen passenden/notwendigen Zeitpunkten erfolgen. Die Kalibrierung erhöht die Zuverlässigkeit der Messungen.

Die folgende Beschreibung von Ausführungsbeispielen erfolgt unter Bezugnahme auf die begleitenden Figuren. Dabei zeigen:
- Fig. 1: eine schematische Darstellung eines Ausführungsbeispiels eines Teils einer Anlage zur Kabelkonfektion;
- Fig. 2: eine Diagrammdarstellung eines Ausführungsbeispiels einer TDR-Messung; und
- Fig. 3: eine schematische Darstellung eines Ausführungsbeispiels einer Schaltung in Bezug auf die Impedanz.

Im Folgenden werden Ausführungsbeispiele im Detail mit Bezug auf die Figuren beschrieben.

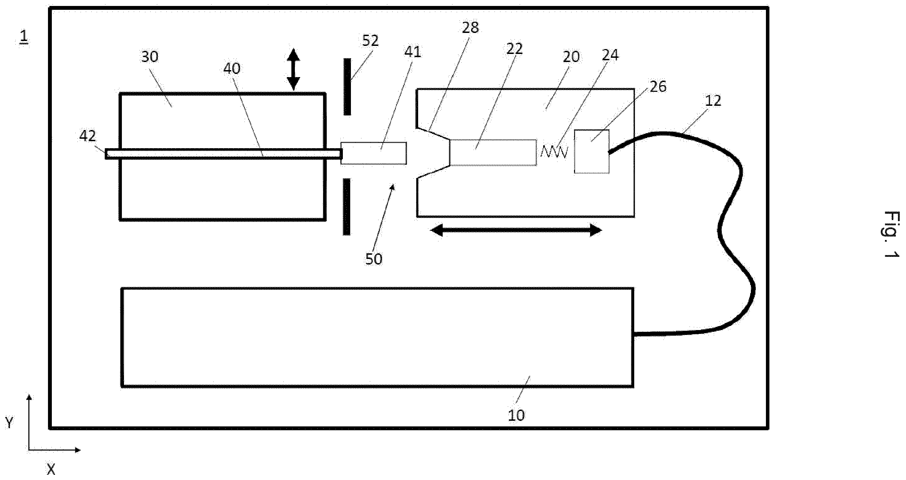

Fig. 1 zeigt ein Ausführungsbeispiel einer Anlage 1 zur Kabel- bzw. Leitungskonfektion. Die Anlage 1 umfasst mehrere Module, die eingerichtet sind eine Leitung 40 mit zumindest einem Stecker zu konfektionieren. Die Module können zum Beispiel ein Crimpmodul für Kontakte und/oder ein Fügemodul für Stecker umfassen. Die Weiterleitung und Verarbeitung zwischen und an den Modulen erfolgt automatisiert für einen schnellen Prozessablauf. Am Ende der Kabelkonfektion soll die fertig konfektionierte Leitung 40 geprüft werden. Mit der in Fig. 1 gezeigten Anlage 1 ist das Prüfen in den automatisierten Prozess integriert.

Für einen Prüfvorgang führt ein Leitungsträger 30, der eine konfektionierte Leitung 40 aufgenommen hat, in den Prüfbereich 50 ein. Die Leitung 40 kann konfektioniert sein, muss jedoch nicht. In dem dargestellten Ausführungsbeispiel greift der Leitungsträger 30 die Leitung 40, um sie sicher zu halten und zu transportieren. In anderen Ausführungsbeispielen sind andere Arten des Haltens möglich. Die Bewegung des Leitungsträgers 30 kann durch einen Roboterarm oder eine Art Förderband realisiert sein. Der Prüfbereich 50 ist bevorzugt durch eine Positionierhilfe 52 gekennzeichnet. In dem dargestellten Ausführungsbeispiel ist die Positionierhilfe 52 eine Blende mit einer Öffnung. Die Öffnung kann zum Beispiel kreisförmig sein und an den maximalen Außenradius des ersten Leitungsendes 41 angepasst sein. In anderen Ausführungsbeispielen kann die Positionierhilfe 52 lediglich eine Markierung umfassen, die den Prüfbereich 50 auszeichnet. Der Leitungsträger 30 positioniert die Leitung 40, insbesondere ein erstes Ende 41 der Leitung 40, in dem Prüfbereich 50. In einem bevorzugten Ausführungsbeispiel bewegt der Leitungsträger 30 dazu die Leitung 40 entlang einer zweiten Richtung Y.

Das erste Ende 41 der Leitung 40 ist bevorzugt konfektioniert, d.h. mit einem Stecker versehen. Der Stecker ist bevorzugt ein Hochfrequenz-tauglicher Stecker. Die Leitung 40 kann zu einem Coil zusammengewickelt sein, um platzsparend transportiert zu werden. Das zweite Ende 42 der Leitung 40 kann konfektioniert sein oder nicht. Die Leitungslänge kann prinzipiell beliebig sein. Insbesondere liegt die Leitungslänge im Bereich von 2,5 cm bis 16 m. Bevorzugt sind die Leitungen 40 für die automatisierte Kabelkonfektion 1-Draht Antennenleitungen mit einer Impedanz von 50 Ω oder 2/4-Draht Datenleitungen, die verdrillt und geschirmt sind und eine differentielle Impedanz von 100 Ω aufweisen.

Die Kontaktierung der zu prüfenden Leitung 40 erfolgt mittels einer Kontaktiervorrichtung 20. Die Kontaktiervorrichtung 20 kontaktiert die Leitung 40 Hochfrequenz-tauglich, was wichtig ist, um TDR-Messungen durchzuführen. Die Kontaktiervorrichtung 20 weist für Messungen einen Kontaktierstift 22 auf, der mittels eines Federelements 24 federnd gelagert ist. Der Kontaktierstift 22 ist bevorzugt metallisch ausgebildet, um Hochfrequenzsignale zu übertragen. Eine optionale Einführhilfe 28 kann das Einführen einer Leitung 40 in die Kontaktiervorrichtung 20 erleichtern. In Fig. 1 ist die Einführhilfe 28 durch zumindest zwei sich verjüngende Seitenflächen gebildet. Andere Formen sind möglich. Die Kontaktiervorrichtung 20 ist über eine Hochfrequenz-Verbindung 12 mit einer TDR-Messvorrichtung 10 verbunden. Über die Hochfrequenz-Verbindung 12 können Gleichstrom- und Wechselstromsignale auch im Hochfrequenz-Bereich, übertragen werden. Bevorzugt ist die Hochfrequenz-Verbindung 12 über ein Bauteil 26 an der Kontaktiervorrichtung 20 angeschlossen. Insbesondere umfasst das Bauteil 26 eine 50 Ω Impedanz Steckverbindung.

Die Kontaktiervorrichtung 20 ist gegenüber der Leitung 40 und der TDR-Messvorrichtung 10 bewegbar. Für eine Leitungsprüfung wird die Kontaktiervorrichtung 20 an dem ersten Ende 41 der Leitung 40 ausgerichtet. Die Kontaktiervorrichtung 20 bewegt sich, bevorzugt entlang einer ersten Richtung X, in Richtung der Leitung 40 bzw. des ersten Leitungsendes 41, welches im Prüfbereich 50 angeordnet ist. Insbesondere bewegt sich die Kontaktiervorrichtung 20 mit integrierter Zentrierung und festem Anschlag soweit in Richtung der Leitung 40, bis die Leitung 40 den federnd gelagerten Kontaktierstift 22 bewegt und das Federelement 24 zusammendrückt. Das Federelement 24 ist dabei nur teilweise zusammengedrückt, so dass es eine Druckkraft in Richtung der Leitung 40 auf den Kontaktierstift 22 ausübt. Insbesondere weist das Federelement 24 einen Arbeitshub auf, der etwa im hinteren Drittel der maximalen Auslegung liegt. In einer alternativen Ausführungsform kann ein anderes Element, das beim Zusammendrücken eine Rückstellkraft aufweist, verwendet werden. Durch die Federung ist der Kontaktierstift 22 dauerhaft in Anschlag mit dem ersten Ende 41 der Leitung 40 und eine Hochfrequenz-taugliche Verbindung ist sichergestellt. Die elektrischen Signale können vom Bauteil 26 über das Federelement 24 oder eine separate Verbindung an dem Kontaktierstift 22 bereitgestellt werden.

In einer Ausführungsform kann eine gute Kontaktierung zum Beispiel erreicht sein, wenn der Kontaktierstift um eine bestimmte Distanz verschoben ist. Die Distanzverschiebung kann detektiert werden und einen Messprozess an der TDR-Messvorrichtung auslösen. Insbesondere kann eine Endposition der Kontaktierung durch einen Sensor erfasst und eine TDR-Messung gestartet werden.

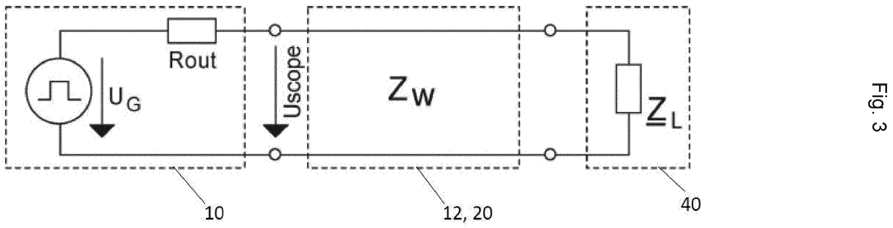

Um eine hohe Signalamplitude an der Leitung 40 bereitzustellen, und ein eindeutig resultierendes Signal zur Auswertung zu erhalten, muss die Verbindung zwischen der TDR-Messvorrichtung 10 und der Leitung 40 Hochfrequenz-tauglich eingerichtet sein. Für eine Hochfrequenz-taugliche Verbindung müssen die Impedanz, d.h. der Wellenwiderstand, der TDR-Messvorrichtung 10, die Kontaktierung zur Leitung 12, 20 und die Leitung 40 die gleiche Impedanz aufweisen (s. Fig. 3). Im beschriebenen Ausführungsbeispiel wird bei 1-Draht Leitungen eine Impedanz von 50 Ω aufgrund von externen Vorgaben verwendet. Eine Impedanz von 50 Ω ist Standard bei Messgeräten und Prüflingen wie Antennenleitungen. Bei einer Koaxialleitung bestimmt insbesondere die Geometrie zwischen Innen- und Außenleiter und dem Dielektrikum den Wellenwiderstand, d.h. die Impedanz.

Die Prüfung der Leitung 40 erfolgt mittels einer TDR-Messvorrichtung 10. Für die Integration einer TDR-Messvorrichtung 10 in eine Produktionsanlage, wurde eine differentielle TDR-Messvorrichtung mit 2 Kanälen, die für eine Fertigungsumgebungen geeignet ist, ausgewählt. Standard TDR-Messvorrichtung sind meist sehr groß und eher für den Laboreinsatz konzipiert. Die ausgewählte TDR-Messvorrichtung 10 basiert auf der sogenannten "Sequential Equivalent Time Sampling" Methode und erreicht damit virtuelle Abtastintervalle von bis zu 10 ps. Mit diesen Abtastintervallen können Leitungen 40, insbesondere mit einer Dielektrizität von 1,7, mit einem Abstand von etwa 1,15 mm aufgelöst werden. Die TDR-Messvorrichtung 10 in dem beschriebenen Ausführungsbeispiel weist (Sprung-) Generatoren und Abtastmodule auf. Die Sprunggeneratoren weisen eine Anstiegszeit von weniger als 65 ps auf und die Messbandbreite der Abtastung ist größer als 10 GHz. Insbesondere weist die TDR-Messvorrichtung 10 keine Totzeit auf, d.h. auch sehr kurze Leitungen 40, mit einer Länge größer als 25 mm, können vermessen werden bzw. vorab zur Kalibrierung verwendet werden.

Die beiden Kanäle der TDR-Messvorrichtung 10 können im Einzelbetrieb (SingleEnded) oder im Differenzmodus (Differential) betrieben werden. Mit dem Differenzmodus ist es möglich Mehrdrahtleitungen gegeneinander zu vermessen bzw. prüfen. Je nach Messmodus, Anzahl der Messpunkte bzw. Länge der Leitung 40, Generatorfrequenz und Auflösung benötigt eine Messung eine gewisse Zeit, eine sogenannte SweepTime. In einem Ausführungsbeispiel benötigt eine Messung von 2 Leitungen 40 mit 8192 Datenpunkten etwa 0,5 s. In einem anderen Ausführungsbeispiel benötigt eine Messung im Einzelbetrieb für die Messung einer 16 m langen Leitung 40 etwa 2,5 s. Mit Hilfe eines Hochfrequenz-Multiplexers ist ein Betrieb auch mit 4 oder 8 Kanälen möglich, so dass mehrere Leitungen 40 gleichzeitig geprüft werden können.

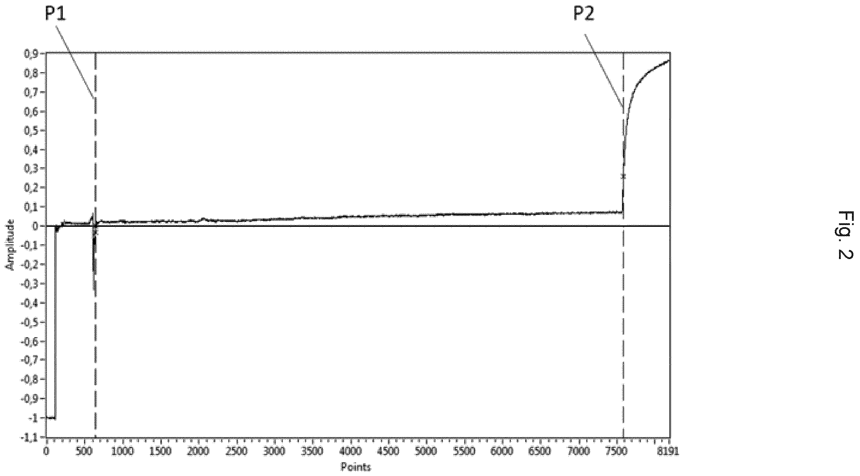

In Fig. 2 ist ein Ausführungsbeispiel einer TDR-Messung dargestellt. Auf der horizontalen Achse sind die Messpunkte, und auf der vertikalen Achse die Signalamplituden dargestellt. Über die Anfangsreflektion (steil ausschlagende negative Amplitude) einer Leitung 40 zwischen dem Kontaktierstift 22 und dem ersten Ende 41 der Leitung 40, d.h. insbesondere am Hochfrequenz-Stecker, (siehe Position P1) und der Totalreflektion (steil ansteigende positive Amplitude) am zweiten Ende 42 der Leitung 40, insbesondere einer offenen, nicht konfektionierten Leitung 40, (siehe Position P2) wird über die Ausbreitungsgeschwindigkeit und die Laufzeit eine Leitungslänge bestimmt. Jeder Messpunkt entspricht einer spezifischen Auflösung der Länge der Leitung 40 mit einer Abtastung von 10 ps. Um die Genauigkeit zu erhöhen kann das System vorab mit einer Messung einer definierten Länge kalibriert werden. Eine Unterbrechung der Leitung 40 äußert sich in einer deutlichen Abweichung vom dargestellten Reflektionsdiagramm sowie einem Unterschreiten der Mindestlänge der Leitung 40.

Mit der beschriebenen Anlage 1 bzw. dem beschriebenen Prüfverfahren können am Ende der automatisierten Konfektion einer Leitung 40 sowohl Gleichstrom-Eigenschaften, wie Durchgang und/oder Kurzschluss, als auch Hochfrequenz-Eigenschaften, wie Reflektion, Impedanz und/oder Laufzeit, bestimmt und automatisch überprüft werden.

Im beschriebenen Ausführungsbeispiel übernimmt ein PC die Steuerung der Messung und die Verarbeitung der Daten von der TDR-Messvorrichtung 10. Die Steuerung der automatischen Zuführung erfolgt über eine SPS. Nach der Prüfung erfolgt die Rückstellung der Kontaktiervorrichtung 20 in die Ausgangslage und die Leitung 40 wird für einen folgenden Prozessschritt, zum Beispiel zur Entnahme, weiter transportiert. Der gleiche oder ein anderer Leitungsträger 30 positioniert und hält eine folgende Leitung 40, und der beschriebene Prozess startet von vorne.

### BEZUGSZEICHENLISTE

- 1: Anlage
- 10: TDR-Messvorrichtung
- 12: Hochfrequenz-Verbindung
- 20: Kontaktiervorrichtung
- 22: Kontaktierstift
- 24: Federelement
- 26: Bauteil
- 28: Einführhilfe
- 30: Leitungsträger
- 40: Leitung
- 41: erstes Ende
- 42: zweites Ende
- 50: Prüfbereich
- 52: Positionierhilfe
- P1: erste Position
- P2: zweite Position
- X: erste Richtung
- Y: zweite Richtung

## Patentansprüche

1. Anlage (1) zur automatisierten Kabelkonfektion aufweisend:
a) mehrere Module, die eingerichtet sind eine Leitung (40) mit zumindest einem Stecker zu konfektionieren;
b) einen Leitungsträger (30), der eingerichtet ist zumindest eine Leitung (40) zu transportieren und zu halten; wobei
c) eine Weiterleitung und Verarbeitung zwischen und an den Modulen automatisiert erfolgt;
d) eine TDR-Messvorrichtung (10), die eingerichtet ist Hochfrequenz-Messungen durchzuführen; und
e) eine Kontaktiervorrichtung (20), die gegenüber der Leitung (40) und der TDR-Messvorrichtung (10) bewegbar ist, und die über eine Hochfrequenz-Verbindung (12) mit der TDR-Messvorrichtung (10) verbunden ist, wobei die Kontaktiervorrichtung (20) die Leitung (40) Hochfrequenz-tauglich kontaktieren kann;
f) einen PC zur Steuerung von Messungen und zur Verarbeitung von gemessenen Daten der TDR-Messvorrichtung (10), und eine SPS zur Steuerung der automatischen Zuführung von Leitungen (40) an der Kontaktiervorrichtung (20); wobei
g) der Leitungsträger (30) eine Bewegung entlang einer zweiten Richtung (Y) quer zur Kontaktiervorrichtung (20) durchführt und die Leitung (40) in einem Prüfbereich (50) positioniert;
h) die Kontaktiervorrichtung (20) zur Kontaktierung der Leitung (40) eine Bewegung entlang einer ersten Richtung (X), in Richtung der Leitung (40), die im Prüfbereich (50) angeordnet ist, durchführt; und
i) die Kontaktiervorrichtung (20) einen federgespannten Kontaktierstift (22) umfasst.

2. Anlage nach Anspruch 1, bei dem die TDR-Messvorrichtung (10) zumindest zwei Kanäle aufweist, und die zumindest zwei Kanäle im Einzelbetrieb oder im Differenzmodus betrieben werden können.

3. Anlage nach Anspruch 1 oder 2, bei dem die TDR-Messvorrichtung (10) auf dem "sequential equivalent-time sampling" Verfahren basiert, und Sprunggeneratoren aufweist, wobei die Sprunggeneratoren eine Anstiegszeit von weniger als 100 ps, bevorzugter weniger als 70 ps, am bevorzugtesten weniger als 65 ps, und eine Messbandbreite von mehr als 5 GHz, bevorzugter mehr als 8 GHz, und am bevorzugtesten mehr als 10 GHz, aufweisen.

4. Anlage nach einem der Ansprüche 1 - 3, bei dem die Leitung (40) zu einem Coil aufgewickelt sein kann, und bevorzugt ein- oder zweiseitig konfektioniert sein kann.

5. Anlage nach einem der Ansprüche 1 - 4, bei dem eine Hochfrequenz-taugliche Verbindung eine gleiche Impedanz von TDR-Messvorrichtung (10), Kontaktierung zur Leitung (12, 20) und Leitung (40) umfasst.

6. Anlage nach einem der Ansprüche 1 - 5, bei dem die TDR-Messvorrichtung (10) einen Hochfrequenz-Multiplexer umfasst.

7. Prüfverfahren für die automatisierte Kabelkonfektion an einer Anlage (1) nach einem der Ansprüche 1 - 6, die zumindest mehrere Module zur Konfektion einer Leitung (40), einen Leitungsträger (30), eine Kontaktiervorrichtung (20), eine TDR-Messvorrichtung (10), die über eine Hochfrequenz-Verbindung (12) mit der Kontaktiervorrichtung (20) verbunden ist, einen PC und eine SPS umfasst, wobei das Verfahren die folgenden Schritte aufweist:
a) automatisiertes Verarbeiten der Leitung (40) an den Modulen;
b) automatisiertes Weiterleiten der Leitung (40) zwischen den Modulen entlang einer zweiten Richtung (Y) quer zur Kontaktiervorrichtung (20);
c) Positionieren der Leitung (40) in einem Prüfbereich (50) gegenüber der Kontaktiervorrichtung (20) mittels des Leitungsträgers (30) und gesteuert durch die SPS;
d) Ausrichten der Kontaktiervorrichtung (20) entlang einer ersten Richtung (X), in Richtung der Leitung (40), die im Prüfbereich (50) angeordnet ist, an der Leitung (40), so dass die Kontaktiervorrichtung (20) in Kontakt mit der Leitung (40) gebracht werden kann;
e) Prüfen der Leitung (40) mittels der TDR-Messvorrichtung (10) und gesteuert durch den PC;
f) nach dem Prüfen, Bewegen der Kontaktiervorrichtung (20) entlang der ersten Richtung (X), in Richtung weg von der Leitung (40), so dass die Leitung (40) mittels des Leitungsträgers (30) frei bewegbar ist;
g) Weitertransportieren der Leitung (40) zu einem nachfolgenden Prozessschritt; und
h) Bereitstellen einer folgenden Leitung (40) mittels des gleichen oder eines anderen Leitungsträgers (30) an der Kontaktiervorrichtung (20).

8. Prüfverfahren nach Anspruch 7, bei dem der Schritt des Ausrichtens der Kontaktiervorrichtung (20) an der Leitung (40) ein Andrücken der Kontaktiervorrichtung (20) an die Leitung (40) umfasst.

9. Prüfverfahren nach Anspruch 7 oder 8, bei dem der Schritt des Prüfens ein Bestimmen der Leitungslänge und/oder einer Unterbrechung der Leitung (40) umfasst.

10. Prüfverfahren nach einem der Ansprüche 7 - 9, bei dem der Schritt des Prüfens ein Bestimmen von Gleichstromeigenschaften umfasst.

11. Prüfverfahren nach einem der Ansprüche 7 - 10, weiterhin aufweisend den Initialschritt:
Kalibrieren des Prüfverfahrens über eine Messung an einer Leitung (40) mit definierter Länge.

## Claims

1. System (1) for automated cable assembly, comprising:
a) a plurality of modules, which are configured to pre-assemble a line (40) with at least one plug;
b) a line carrier (30), which is configured to transport and hold at least one line (40); wherein
c) forwarding and processing between and to the modules take place in an automated manner;
d) a TDR measuring device (10), which is configured to perform radio-frequency measurements; and
e) a contacting device (20), which can be moved in relation to the line (40) and the TDR measuring device (10) and is connected to the TDR measuring device (10) via a radio-frequency connection (12), wherein the contacting device (20) can contact the line (40) with radio-frequency capability;
f) a PC for controlling measurements and for processing measured data from the TDR measuring device (10), and a PLC for controlling the automatic supply of lines (40) to the contacting device (20); wherein
g) the line carrier (30) performs a movement along a second direction (Y) transversely to the contacting device (20) and positions the line (40) in a test area (50);
h) the contacting device (20), for contacting the line (40), performs a movement along a first direction (X), in the direction of the line (40) which is arranged in the test area (50); and
i) the contacting device (20) comprises a spring-loaded contacting pin (22).

2. System according to Claim 1, in which the TDR measuring device (10) has at least two channels, and the at least two channels can be operated with single-ended operation or in differential mode.

3. System according to Claim 1 or 2, in which the TDR measuring device (10) is based on the "sequential equivalent-time sampling" method and has step generators, wherein the step generators have a rise time of less than 100 ps, preferably less than 70 ps, most preferably less than 65 ps, and a measurement bandwidth of more than 5 GHz, more preferably more than 8 GHz, and most preferably more than 10 GHz.

4. System according to any of Claims 1-3, in which the line (40) can be wound up to form a coil, and preferably can be pre-assembled on one or two sides.

5. System according to any of Claims 1-4, in which a connection with radio-frequency capability comprises an equal impedance of the TDR measuring device (10), the contacting means to the line (12, 20) and the line (40).

6. System according to any of Claims 1-5, in which the TDR measuring device (10) comprises a radio-frequency multiplexer.

7. Test method for automated cable assembly in a system (1) according to any of Claims 1-6 which comprises at least a plurality of modules for assembly of a line (40), a line carrier (30), a contacting device (20), a TDR measuring device (10), which is connected to the contacting device (20) via a radio-frequency connection (12), a PC and a PLC, wherein the method comprises the following steps:
a) automated processing of the line (40) on the modules;
b) automated forwarding of the line (40) between the modules along a second direction (Y) perpendicularly to the contacting device (20);
c) positioning the line (40) in a test area (50) in relation to the contacting device (20) by means of the line carrier (30) and in a manner controlled by the PLC;
d) aligning the contacting device (20) with the line (40) along a first direction (X), in the direction of the line (40) which is arranged in the test area (50), so that the contacting device (20) can be brought into contact with the line (40);
e) testing the line (40) by means of the TDR measuring device (10) and in a manner controlled by the PC;
f) after testing, moving the contacting device (20) along the first direction (X), in the direction away from the line (40), so that the line (40) can be moved freely by means of the line carrier (30);
g) further transporting the line (40) to a subsequent process step; and
h) providing a following line (40) to the contacting device (20) by means of the same or another line carrier (30).

8. Test method according to Claim 7, in which the step of aligning the contacting device (20) with the line (40) comprises pressing the contacting device (20) against the line (40).

9. Test method according to Claim 7 or 8, in which the testing step comprises determining the line length and/or an interruption in the line (40).

10. Test method according to any of Claims 7-9, in which the testing step comprises determining DC properties.

11. Test method according to any of Claims 7-10, further comprising the initial step:
calibrating the test method by means of a measurement on a line (40) of defined length.

## Revendications

1. Installation (1) pour la confection automatisée de câbles, possédant :
a) plusieurs modules qui sont conçus pour confectionner un câble (40) doté d'au moins une fiche ;
b) un porte-câble (30), qui est conçu pour transporter et maintenir au moins un câble (40) ;
c) un transfert et un traitement qui s'effectuent de manière automatisée entre et sur les modules ;
d) un dispositif de mesure TDR (10), qui est conçu pour effectuer des mesures à haute fréquence ; et
e) un dispositif d'établissement de contact (20), qui est mobile par rapport au câble (40) et au dispositif de mesure TDR (10) et qui est relié au dispositif de mesure TDR (10) par le biais d'une liaison haute fréquence (12), le dispositif d'établissement de contact (20) pouvant entrer en contact avec le câble (40) de manière compatible avec la haute fréquence ;
f) un PC destiné à commander les mesures et à traiter les données mesurées par le dispositif de mesure TDR (10), et un API destiné à commander l'amenée automatique des câbles (40) au dispositif d'établissement de contact (20) ;
g) le porte-câble (30) effectuant un mouvement le long d'une deuxième direction (Y) transversalement au dispositif d'établissement de contact (20) et positionnant le câble (40) dans une zone de contrôle (50) ;
h) le dispositif d'établissement de contact (20) destiné à entre en contact avec le câble (40) effectuant un mouvement le long d'une première direction (X), en direction du câble (40) qui est disposé dans la zone de contrôle (50) ; et
i) le dispositif d'établissement de contact (20) comportant une broche d'établissement contact (22) montée sur ressort.

2. Installation selon la revendication 1, avec laquelle le dispositif de mesure TDR (10) possède au moins deux canaux, et les au moins deux canaux peuvent fonctionner en mode individuel ou en mode différentiel.

3. Installation selon la revendication 1 ou 2, avec laquelle le dispositif de mesure TDR (10) est basé sur le procédé « échantillonnage séquentiel en temps équivalent » et possède des générateurs de sauts, les générateurs de sauts ayant un temps de montée inférieur à 100 ps, de préférence inférieur à 70 ps, plus préférentiellement inférieur à 65 ps, et une largeur de bande de mesure supérieure à 5 GHz, de préférence supérieure à 8 GHz et plus préférentiellement supérieure à 10 GHz.

4. Installation selon l'une des revendications 1 à 3, avec laquelle le câble (40) peut être enroulé en une bobine et peut être de préférence confectionné avec un ou deux côtés.

5. Installation selon l'une des revendications 1 à 4, avec laquelle une connexion compatible avec la haute fréquence comprend une impédance identique au dispositif de mesure TDR (10), à l'établissement du contact avec le câble (12, 20) et au câble (40).

6. Installation selon l'une des revendications 1 à 5, avec laquelle le dispositif de mesure TDR (10) comprend un multiplexeur haute fréquence.

7. Procédé de contrôle pour la confection automatisée de câbles sur une installation (1) selon l'une des revendications 1 à 6, qui comprend au moins plusieurs modules destinés à la confection d'un câble (40), un porte-câble (30), un dispositif d'établissement de contact (20), un dispositif de mesure TDR (10), qui est relié au dispositif d'établissement de contact (20) par le biais d'une liaison haute fréquence (12), un PC et un API, le procédé comprenant les étapes suivantes :
a) traitement automatisé du câble (40) au niveau des modules ;
b) transfert automatisé du câble (40) entre les modules le long d'une deuxième direction (Y) transversale au dispositif d'établissement de contact (20) ;
c) positionnement du câble (40) dans une zone de contrôle (50) en face du dispositif d'établissement de contact (20) au moyen du porte-câble (30) et par commande de l'API ;
d) alignement du dispositif d'établissement de contact (20) le long d'une première direction (X), en direction du câble (40) qui est disposé dans la zone de contrôle (50), sur le câble (40), de telle sorte que le dispositif d'établissement de contact (20) puisse être amené en contact avec le câble (40) ;
e) contrôle du câble (40) au moyen du dispositif de mesure TDR (10) et par commande du PC ;
f) après le contrôle, déplacement du dispositif d'établissement de contact (20) le long de la première direction (X), dans une direction s'éloignant du câble (40), de telle sorte que le câble (40) puisse se déplacer librement au moyen du porte-câble (30) ;
g) poursuite du transport du câble (40) vers une étape suivante du processus ; et
h) fourniture d'un câble suivant (40) au moyen du même porte-câble (30) ou d'un autre au niveau du dispositif d'établissement de contact (20).

8. Procédé de contrôle selon la revendication 7, dans lequel l'étape d'alignement du dispositif d'établissement de contact (20) sur le câble (40) comprend un pressage du dispositif d'établissement de contact (20) contre le câble (40).

9. Procédé de contrôle selon la revendication 7 ou 8, dans lequel l'étape de contrôle comprend une détermination de la longueur du câble et/ou d'une interruption du câble (40).

10. Procédé de contrôle selon l'une des revendications 7 à 9, dans lequel l'étape de contrôle comprend la détermination des propriétés en courant continu.

11. Procédé selon l'une des revendications 7 à 10, comprenant en outre l'étape initiale :
calibrage du procédé de contrôle par le biais d'une mesure effectuée sur un câble (40) de longueur définie.
